# EUROPEAN PATENT SPECIFICATION

(11) **EP 3 457 823 B1**
(45) Date of publication and mention of the grant of the patent: **14.10.2026**
(21) Application number: 18195346.4
(22) Date of filing: 24.04.2009
(51) Int. Cl.: H05K 3/40, H05K 1/02, H05K 3/46

(54) **MULTI-LAYER CIRCUIT BOARD AND COMMUNICATION DEVICE**
MEHRSCHICHTIGE LEITERPLATTE UND KOMMUNIKATIONSVORRICHTUNG
CARTE DE CIRCUIT IMPRIMÉ MULTICOUCHES ET DISPOSITIF DE COMMUNICATION

(30) Priority: 28.09.2008 CN 200810216597; 22.01.2009 CN 200910005975
(43) Date of publication of application: 20.03.2019
(62) Document number(s) of the earlier application(s) in accordance with Art. 76 EPC: 14179125.1 / 2 822 369; 11192345.4 / 2 429 270; 09815564.1 / 2 227 076
(73) Proprietor: Huawei Technologies Co., Ltd., Longgang District Shenzhen, Guangdong 518129 (CN)
(72) Inventor: Huang, Mingli, Shenzhen, Guangdong (CN); Zhang, Shun, Shenzhen, Guangdong (CN); Yang, Xichen, Shenzhen, Guangdong (CN); Zhao, Junying, Shenzhen, Guangdong (CN); Luo, Bing, Shenzhen, Guangdong (CN); Li, Zhihai, Shenzhen, Guangdong (CN); Wang, Guoliang, Shenzhen, Guangdong (CN)
(74) Representative: Huawei European IPR

(56) References cited:
- EP-A1- 1 628 515
- EP-A2- 0 926 729
- EP-A2- 1 261 028
- WO-A1-2004/103038
- WO-A1-2006/059923
- WO-A1-2006/059925
- WO-A1-2007/096313
- CN-Y- 2 531 525
- US-A1- 2003 100 197
- US-A1- 2007 284 711
- US-A1- 2008 158 821
- US-B1- 6 200 407

## Description

### FIELD OF THE TECHNOLOGY

The present invention relates to the field of an electronic communication technology, and more particularly to a multi-layer circuit board, a method of manufacturing the multi-layer circuit board, and a communication device.

### BACKGROUND OF THE INVENTION

With the prosperous development of the electronic industry, circuit boards have been widely used. Electronic components are usually assembled on a circuit board for performing operations, such as a power tube, a quad flat non-leaded (QFN) package, a ball grid array (BGA), a chip scale package (CSP), and a quad flat package (QFP). With the continuous increasing of the electronic components on the circuit board, a heat dissipation issue becomes more and more important.

For the electronic components with large power, currently, the heat dissipation is usually performed on such electronic components by partially embedding a metal substrate in a corresponding circuit board.

It has become apparent that the prior art at least has the following problems.

The partially embedded metal substrate requires being assembled independently, which increases the technical procedures and also requires an assistant technical assembly, thereby affecting the production efficiency.

WO 2004/103038 A1 discloses microelectronic substrates with thermally conductive pathways.

EP0926729A2 discloses a semiconductor plastic package structure, wherein a metal sheet of nearly the same size as the printed circuit board nearly in the center in the thickness direction of the printed circuit board.

CN2531525Y discloses a circuit board comprising a heat-dissipating BGA substrate.

### SUMMARY OF THE INVENTION

Accordingly, the present invention is directed to a circuit board having a heat conducting block and a communication device. The heat conducting block is embedded when the circuit board is pressed, thereby simplifying an assembling process of the heat conducting block. The invention is set out in the appended set of claims which include two independent product claims describing two alternative products.

### BRIEF DESCRIPTION OF THE DRAWINGS

To illustrate the technical solutions according to the embodiments of the present invention or in the prior art more clearly, the accompanying drawings required for describing the embodiments or the prior art are introduced below briefly. Apparently, the accompanying drawings in the following descriptions merely show some of the embodiments of the present invention.
FIG. 1 is a schematic diagram of a daughter board in a method of manufacturing a multi-layer circuit board according to an embodiment of the present invention;
FIG. 2 is a schematic diagram of a method of manufacturing a multi-layer circuit board according to an embodiment of the present invention;
FIG. 3 is a schematic diagram of a method of manufacturing a multi-layer circuit board according to another embodiment of the present invention;
FIG. 4 is a schematic diagram of a multi-layer circuit board according to an embodiment of the present invention;
FIG. 5 is a schematic diagram of a multi-layer circuit board according to an illustrative example.
FIG. 6 is a schematic diagram of a plurality of receiving slots placed in a multi-layer circuit board according to a first embodiment of the present invention;
FIG. 7 is a schematic diagram of a plurality of receiving slots placed in a multi-layer circuit board according to a second embodiment of the present invention;
FIG. 8 is a schematic diagram of a plurality of receiving slots placed in a multi-layer circuit board according to a third embodiment of the present invention;
FIG. 9 is a schematic diagram of a heat conducting block of a multi-layer circuit board according to an embodiment of the present invention;
FIG. 10 is a schematic diagram of a heat conducting block of a multi-layer circuit board according to another embodiment of the present invention;
FIG. 11 is a schematic top diagram of a heat conducting block of a multi-layer circuit board according to yet another embodiment of the present invention; and
FIG. 12 is a schematic diagram of a heat conducting block of a multi-layer circuit board according to a further embodiment of the present invention.

### DETAILED DESCRIPTION OF THE EMBODIMENTS

The technical solutions of the embodiments of the present invention are described below clearly with reference to the accompanying drawings. Apparently, the embodiments in the following descriptions are merely part of the embodiments of the present invention, rather than all the embodiments of the present invention. Persons of ordinary skill in the art can derive other embodiments based on the embodiments of the present invention without creative efforts, which all fall within the scope of the appended claims.

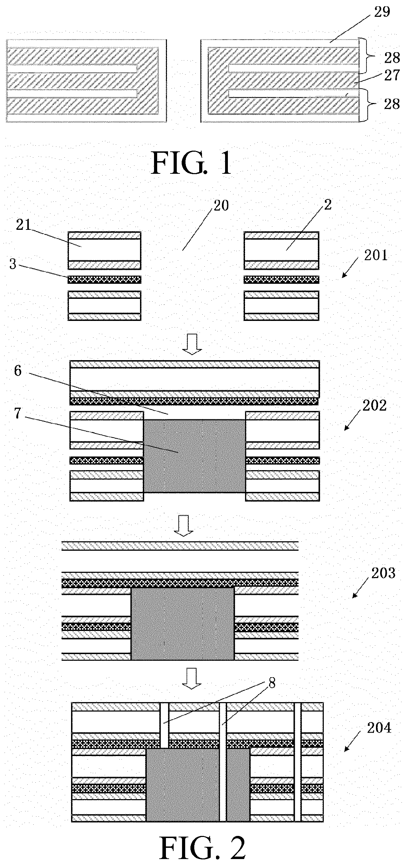

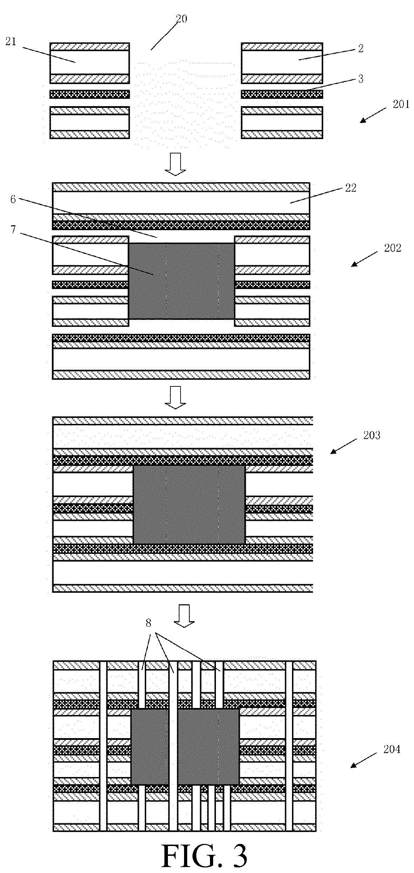

As shown in FIG. 2 or 3, in an embodiment, the present invention provides a method of manufacturing a multi-layer circuit board. The method includes the following steps.

In step 201, a slot segment 20 is opened on at least one daughter board 2 to form a first daughter board 21.

In step 202, at least one daughter board 2 and medium layers 3 are stacked together. The daughter boards 2 include first daughter boards 21. The first daughter boards 21 are placed in such a way that the slot segments 20 of the first daughter boards 21 are communicated. The slot segments 20 are communicated to form a receiving slot 6. A heat conducting block 7 is placed within the receiving slot 6. Each medium layer 3 is sandwiched between the daughter boards 2.

In step 203, the stacked daughter boards 2, medium layers 3, and heat conducting block 7 are pressed together, and then the daughter boards and the heat conducting block are made into a multi-layer circuit board.

In the embodiment of the present invention, the heat conducting block is embedded in the circuit board when the daughter boards are pressed together, so that the technical procedures are quite simple and an assembling efficiency of the heat conducting block is increased.

In the embodiment of the present invention, in step 203, after the pressing process, the heat conducting block is lower than or aligned with a surface of the circuit board, or even higher than the surface of the circuit board.

As shown in FIG. 2 to FIG. 5, in an embodiment of the present invention, the daughter boards may include a first daughter board 21 and second daughter boards 22 on which no slot segment is opened. The second daughter boards 22 are located at one end or two ends of the receiving slot 6. Under this situation, the present invention may further include step 204, in which a heat conducting via 8 connected to the heat conducting block is opened beside the heat conducting block. In addition, the heat conducting via 8 may also be drilled in other positions of the multi-layer circuit board.

As shown in FIG. 2 to FIG. 5, in the embodiment of the present invention, each medium layer being sandwiched between adjacent daughter boards can be realized as the following situations.

The medium layer 3 is sandwiched between two first daughter boards 21, and a slot segment is opened between the slot segments 20 of the two first daughter boards 21. Alternatively, the medium layer 3 is sandwiched between two second daughter boards 22. Alternatively, the medium layer 3 is sandwiched between the first daughter board 21 and the second daughter board 22. A slot segment is opened on the medium layer 3. The slot segment of the medium layer is communicated with the slot segment 20 of the first daughter board 21. Alternatively, the medium layer 3 is sandwiched between the first daughter board 21 and the second daughter board 22, and a slot segment is not opened on the medium layer 3.

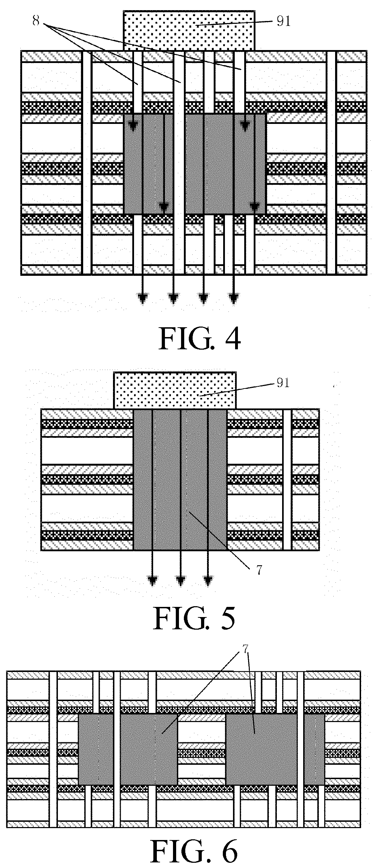

Referring to FIG. 2 to FIG. 5, in an embodiment of the present invention, the heat conducting via 8 is connected to the heat conducting block 7 and an electronic component 91, or connected to the heat conducting block 7 and the surface of the circuit board, or connected to the heat conducting block 7, the electronic component 91, and the surface of the circuit board, or connected to the heat conducting block 7, the electronic component 91, and a heat dissipation component embedded inside the circuit board. The heat conducting via 8 transfers the heat of the electronic component 91 to the heat conducting block 7, or transfers the heat in the heat conducting block 7 to the surface of the circuit board, or transfers the heat of the electronic component 91 to the heat conducting block 7 and then transfers the heat in the heat conducting block 7 to the surface of the circuit board (the arrows in FIG. 4 and FIG. 5 indicate heat transferring paths), or transfers the heat of the electronic component 91 to the heat conducting block 7 and then transfers the heat in the heat conducting block 7 to the heat dissipation component.

A heat conducting block is placed inside a multi-layer circuit board, and transfers the heat generated by the electronic components within the circuit board, thus decreasing the heat resistance and increasing the local heat dissipation capability of the circuit board.

In an embodiment of the present invention, the heat conducting via may be filled through electroplating, or inserted with a conductive silver paste to increase the heat dissipation effect.

In an embodiment of the present invention, the heat conducting block is made of a material with heat conductivity higher than that of the circuit board medium, such as copper, aluminum, or a metal alloy.

A shape of the heat conducting block may be a regular column, ball, or cone shape, or may also be an irregular three-dimensional shape. Correspondingly, a shape of the receiving slot matches with the shape of the heat conducting block, so that the heat conducting block is placed within the receiving slot. Therefore, the heat conducting block is prevented from falling off from the receiving slot or shaking inside the receiving slot after the daughter boards and the heat conducting block are pressed together due to an excessively large size of the receiving slot. Furthermore, the heat conducting block is prevented from being damaged during the mutual pressing with the daughter boards after the daughter boards and the heat conducting block are pressed together due to an excessively small size of the receiving slot.

As shown in FIG. 5, in an illustrative example, all the daughter boards may be first daughter boards. After the heat conducting block 7 is placed within the receiving slot, two ends of the heat conducting block are located at external surfaces of the multi-layer circuit board. Each end face of the heat conducting block 7 is aligned with the surface of the circuit board, or higher than the surface of the circuit board, or lower than the surface of the circuit board.

In an embodiment of the present invention, the heat conducting block 7 includes a main body 71 and a connecting body 72 fixedly connected above the main body 71. A sectional area of the connecting body 72 is smaller than that of the main body 71. The shape of the receiving slot matches with the shape of the heat conducting block. The main body 71 and the connecting body 72 may be formed integrally, that is, forming an integral structure.

In an embodiment of the present invention, a sectional area of the connecting body 72 on the top of the heat conducting block 7 is relatively small. The connecting body 72 may be connected to a heat dissipation pad at the bottom of the electronic component through soldering tin. A sectional area of the main body 71 at the bottom of the heat conducting block 7 is relatively large, and the main body 71 contacts a bottom of a metal housing or a substrate of the circuit board. In other words, through embedding a step-like heat conducting block, the heat resistance is much lower than that of the heat dissipation mode by using vias, thereby sufficiently ensuring a contact area and decreasing the contact heat resistance. Moreover, the multi-layer circuit board is enabled to be assembled with components at two side surfaces thereof, so as to facilitate the component layout.

A shoulder 711 is configured at a position on the main body 71 where the connecting body 72 is correspondingly bonded. The shoulder 711 is parallel with a surface of the daughter board 21, and preferably, the shoulder 711 is located on a lower surface of the medium layer 3.

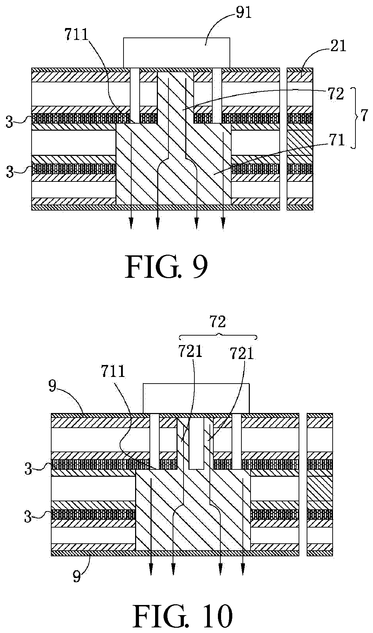

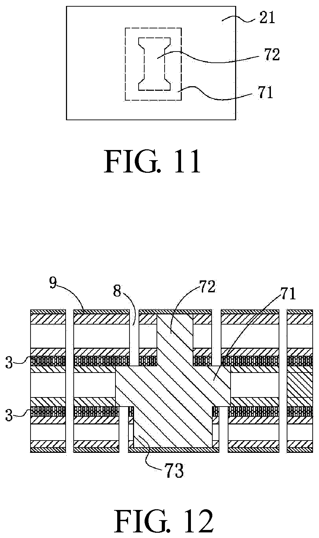

The connecting body may be an integral part, as shown in FIG. 9, or may include more than two connecting sub-bodies 721. Each connecting sub-body 721 is separately placed, and is connected to the main body 71. As shown in FIG. 10, the two connecting sub-bodies 721 are fixedly connected above the main body 71 separately, in parallel, and alternately. Additionally, the connecting body 72 may be designed into any shape depending on the demand of electrical performance, including any regular or irregular shape as shown in FIG. 11. The connecting body 72 may be configured into a step-like shape depending on the actual demand, so that the heat conducting block has a plurality of steps in a height direction.

In an embodiment of the present invention, as shown in FIG. 12, the heat conducting block 7 further includes a connecting piece 73. The connecting piece 73 is fixedly connected below the main body 71. A sectional area of the connecting piece 73 is smaller than that of the main body 71.

In an embodiment of the present invention, an electroplated layer 9 is separately placed on an upper surface and a lower surface of the multi-layer circuit board. In this case, a height of the heat conducting block is preferably equal to a height of the multi-layer circuit board, so that the heat conducting block 7 keeps contacting the two electroplated layers 9, so as to form a heat transferring channel.

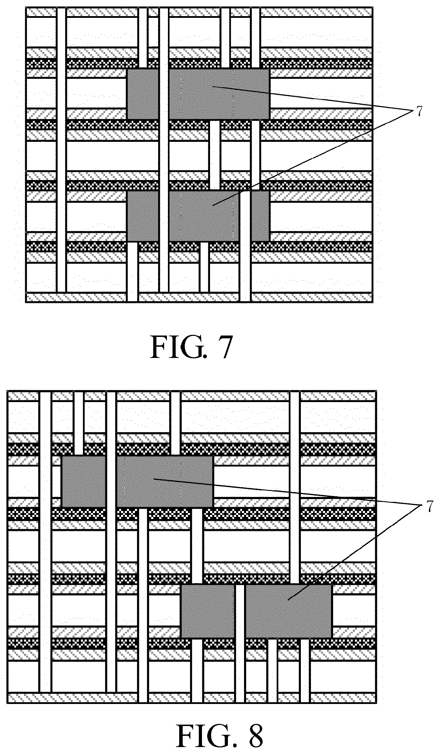

As shown in FIG. 6 to FIG. 8, in an embodiment of the present invention, the stacking sequence of the plurality of first daughter boards may be adjusted, or the slot segments may be opened at different positions, so that the plurality of slot segments is combined into a plurality of receiving slots 6. Alternatively, a plurality of slot segments may be opened at different positions of a first daughter board, and the plurality of slot segments is communicated with slot segments of the other first daughter boards, so as to form a plurality of receiving slots 6. A heat conducting via may be placed between the plurality of receiving slots 6.

The plurality of receiving slots 6 may be arranged side by side, or arranged vertically up and down, or staggered in an up and down direction. Sectional shapes of the slot segments of the plurality of daughter boards may be the same or different. The sectional areas thereof may be the same or different.

In an embodiment of the present invention, the medium layer may be a low-flow B-stage prepreg, or a low-flow B-stage prepreg combined with a C-stage prepreg, so that the medium layer has stretching characteristics and is capable of compensating a height error in manufacturing the heat conducting block, so as to ensure the surface flatness of the multi-layer circuit board. Definitely, the medium layer may also be another adhesive medium.

As shown in FIG. 1, in an embodiment of the present invention, the daughter board may be formed by at least one core material 28. In the situation that the daughter board has a plurality of core materials 28, the plurality of core materials 28 is pressed together. A medium layer 27 is filled between adjacent core materials 28. A pattern layer 29 may be further placed at an external side of the plurality of core materials 28. The medium layer 27 is filled between the pattern layer 29 and the corresponding core material 28.

In an embodiment of the present invention, an outer layer of the daughter board may be a core material or a separate pattern layer. As the daughter board is adapted to form a multi-layer circuit board, a daughter board located at an outmost layer of the multi-layer circuit board may only have a pattern layer on an inward side surface. It should be noted that, the pattern layer on the inward side surface of the daughter board may be a separate pattern layer or a pattern layer of a core material. The daughter board at the outmost layer of the multi-layer circuit board may have or not have a pattern layer on an outward side surface thereof. It should be noted that, the pattern layer on the outward side surface of the daughter board may be a separate pattern layer or a pattern layer of a core material.

Those of ordinary skill in the art should understand that, all or a part of processes in the method according to the embodiments may be accomplished by relevant hardware under instructions of a computer program. The program may be stored in a computer-readable storage medium. When the program is executed, the flow of the method according to the embodiments of the present invention is performed. The storage medium may be a magnetic disk, an optical disk, a read-only memory (ROM), a random access memory (RAM), and the like.

According to the embodiment, as shown in FIG. 2 or 3, the present invention further provides a multi-layer circuit board, which includes a heat conducting block 7 and a plurality of daughter boards 2 and medium layers 3 that are stacked together. The daughter boards 2 include first daughter boards 21. Slot segments 20 are opened on the first daughter boards 21. The slot segments 20 of the plurality of first daughter boards 21 are communicated to form a receiving slot 6. The heat conducting block 7 is placed within the receiving slot 6. Each medium layer 3 is sandwiched between the daughter boards 2.

In an embodiment of the present invention, the heat conducting block is placed inside the multi-layer circuit board, and the heat generated by electronic components is transferred within the circuit board through the heat conducting block, so that the heat resistance is decreased and the local heat dissipation capability of the circuit board is increased.

In the embodiment of the present invention, the heat conducting block is lower than or aligned with a surface of the circuit board, or even higher than the surface of the circuit board.

Based on the above embodiments, as shown in FIG. 2 or 3, the present invention further provides a communication device, which includes at least one multi-layer circuit board. The multi-layer circuit board includes a heat conducting block 7 and a plurality of daughter boards 2 and medium layers 3 that are stacked together. The daughter boards 2 include first daughter boards 21. Slot segments 20 are opened on the first daughter boards 21. The slot segments 20 of the plurality of first daughter boards 21 are communicated to form a receiving slot 6. The heat conducting block 7 is placed within the receiving slot 6. Each medium layer 3 is sandwiched between the daughter boards 2.

In the embodiments of the present invention, the heat conducting block is placed inside the multi-layer circuit board, and the heat generated by electronic components is transferred within the circuit board through the heat conducting block, so that the heat resistance is decreased and the local heat dissipation capability of the circuit board is increased.

## Claims

1. A multi-layer circuit board, comprising: a heat conducting block (7), and a plurality of assembled boards (2) and medium layers (3) that are stacked together, wherein the assembled boards (2) comprise first core boards(21) and second core boards(22), wherein a slot segment (20) is opened on the first core boards (21) and no slot segment is opened on the second core boards(22), the first core boards when assembled join the slot segments (20) to form a receiving slot (6), the heat conducting block(7) is placed within the receiving slot (6), and each medium layer(3) is sandwiched between the assembled boards(2), wherein heat conducting vias (8) are connected to the heat conducting block (7) in which one or more vias (8) pass through the heat conducting block (7).

2. A multi-layer circuit board, comprising: a heat conducting block (7), and a plurality of assembled boards (2) and medium layers (3) that are stacked together, and each medium layer (3) is sandwiched between the assembled boards(2), wherein the assembled boards (2) comprise first core boards(21), a slot segment (20) is opened on the first core board (21), the slot segments of the plurality of first core boards are communicated to form a receiving slot (6), the heat conducting block is placed within the receiving slot, wherein the heat conducting block (7) comprises a main body (71) and a connecting body (72) fixedly connected above the main body, a sectional area of the connecting body is smaller than a sectional area of the main body, the shape of the receiving slot (6) matches with the shape of the heat conducting block, a shoulder (711) is configured at a position on the main body (71) where the connecting body (72) is correspondingly bonded, the shoulder (711) is parallel with a surface of the first core board (21), and the shoulder (711) is located on a lower surface of the medium layer (3).
**characterized in that** a heat conducting via (8) connected to the heat conducting block (7) is opened beside the heat conducting block.

3. The multi-layer circuit board according to claim 1, wherein the second core board is located at one end or two ends of the receiving slot.

4. The multi-layer circuit board according to claim 2, wherein all the assembled boards (2) are first core boards (21), and wherein two ends of the heat conducting block are located at external surface of the multi-layer circuit board after the heat conducting block is placed within the receiving slot.

5. The multi-layer circuit board according to claim 2, wherein the connecting body (72) is an integral part, or comprises more than two connecting sub-bodies (721).

6. The multi-layer circuit board according to claim 2 or 5, wherein the heat conducting block further comprises a connecting piece, the connecting piece is fixedly connected below the main body, a sectional area of the connecting piece is smaller than a sectional area of the main body.

7. The multi-layer circuit board according to any one of claims 1 to 6, wherein the heat conducting block is made of a material with heat conductivity higher than heat conductivity of the circuit board.

8. A communication device, comprising at least one multi-layer circuit board according to any one of claims 1 to 7.

## Patentansprüche

1. Mehrschichtige Leiterplatte, die Folgendes umfasst: einen Wärmeleitblock (7) und mehrere montierte Platinen (2) und Medium-Schichten (3), die zusammengestapelt sind, wobei die montierten Platinen (2) erste Kernplatinen (21) und zweite Kernplatinen (22) umfassen, wobei ein Schlitzsegment (20) auf den ersten Kernplatinen (21) geöffnet ist und kein Schlitzsegment auf den zweiten Kernplatinen (22) geöffnet ist, die ersten Kernplatinen bei Montage die Schlitzsegmente (20) verbinden, um einen Aufnahmeschlitz (6) zu bilden, der Wärmeleitblock (7) in dem Aufnahmeschlitz (6) platziert ist und jede Medium-Schicht (3) zwischen den montierten Platinen (2) zwischengeordnet ist, wobei wärmeleitende Durchkontaktierungen (8) mit dem Wärmeleitblock (7) verbunden sind, wobei eine oder mehrere Durchkontaktierungen (8) durch den Wärmeleitblock (7) verlaufen.

2. Mehrschichtige Leiterplatte, die Folgendes umfasst: einen Wärmeleitblock (7) und mehrere montierte Platinen (2) und Medium-Schichten (3), die zusammengestapelt sind, und jede Medium-Schicht (3) ist zwischen den montierten Platinen (2) zwischengeordnet, wobei die montierten Platinen (2) erste Kernplatinen (21) umfassen, ein Schlitzsegment (20) auf der ersten Kernplatine (21) geöffnet ist, die Schlitzsegmente der mehreren ersten Kernplatinen verbunden sind, um einen Aufnahmeschlitz (6) zu bilden, der Wärmeleitblock in dem Aufnahmeschlitz platziert ist, wobei der Wärmeleitblock (7) einen Hauptkörper (71) und einen Verbindungskörper (72) umfasst, der oberhalb des Hauptkörpers fest verbunden ist, eine Querschnittsfläche des Verbindungskörpers kleiner als eine Querschnittsfläche des Hauptkörpers ist, die Form des Aufnahmeschlitzes (6) mit der Form des Wärmeleitblocks übereinstimmt, eine Schulter (711) an einer Position an dem Hauptkörper (71) ausgebildet ist, an der der Verbindungskörper (72) entsprechend gebondet ist, die Schulter (711) parallel zu einer Oberfläche der ersten Kernplatine (21) ist und sich die Schulter (711) auf einer unteren Oberfläche der Medium-Schicht (3) befindet.
**dadurch gekennzeichnet, dass** neben dem Wärmeleitblock eine mit dem Wärmeleitblock (7) verbundene wärmeleitende Durchkontaktierung (8) geöffnet ist.

3. Mehrschichtige Leiterplatte nach Anspruch 1, wobei sich die zweite Kernplatine an einem Ende oder zwei Enden des Aufnahmeschlitzes befindet.

4. Mehrschichtige Leiterplatte nach Anspruch 2, wobei alle montierten Platinen (2) erste Kernplatinen (21) sind und wobei sich zwei Enden des Wärmeleitblocks nach Platzieren des Wärmeleitblocks in dem Aufnahmeschlitz an einer Außenfläche der mehrschichtigen Leiterplatte befinden.

5. Mehrschichtige Leiterplatte nach Anspruch 2, wobei der Verbindungskörper (72) ein integraler Teil ist oder mehr als zwei Verbindungsteilkörper (721) umfasst.

6. Mehrschichtige Leiterplatte nach Anspruch 2 oder 5, wobei der Wärmeleitblock ferner ein Verbindungsstück umfasst, das Verbindungsstück unterhalb des Hauptkörpers fest verbunden ist, wobei eine Querschnittsfläche des Verbindungsstücks kleiner als eine Querschnittsfläche des Hauptkörpers ist.

7. Mehrschichtige Leiterplatte nach einem der Ansprüche 1 bis 6, wobei der Wärmeleitblock aus einem Material mit einer Wärmeleitfähigkeit hergestellt ist, die höher als die Wärmeleitfähigkeit der Leiterplatte ist.

8. Kommunikationsvorrichtung, die mindestens eine mehrschichtige Leiterplatte nach einem der Ansprüche 1 bis 7 umfasst.

## Revendications

1. Carte de circuit imprimé multicouche, comprenant : un bloc conducteur thermique (7) et une pluralité de cartes assemblées (2) et de couches intermédiaires (3) empilées ensemble, les cartes assemblées (2) comprenant des premières cartes noyaux (21) et des deuxièmes cartes noyaux (22), un segment de fente (20) étant ouvert sur les premières cartes noyaux (21) et aucun segment de fente n'étant ouvert sur les deuxièmes cartes noyaux (22), les premières cartes noyaux, lorsqu'elles sont assemblées, joignant les segments de fente (20) pour former une fente de réception (6), le bloc conducteur thermique (7) étant placé dans la fente de réception (6), et chaque couche intermédiaire (3) étant intercalée entre les cartes assemblées (2), des vias conducteurs thermiques (8) étant en liaison avec le bloc conducteur thermique (7), un ou plusieurs vias (8) traversant le bloc conducteur thermique (7).

2. Carte de circuit imprimé multicouche, comprenant : un bloc conducteur thermique (7) et une pluralité de cartes assemblées (2) et de couches intermédiaires (3) empilées ensemble, et chaque couche intermédiaire (3) étant intercalée entre les cartes assemblées (2), les cartes assemblées (2) comprenant des premières cartes noyaux (21), un segment de fente (20) étant ouvert sur la première carte noyau (21), les segments de fente de la pluralité des premières cartes noyaux étant mis en communication pour former une fente de réception (6), le bloc conducteur thermique étant placé dans la fente de réception, le bloc conducteur thermique (7) comprenant un corps principal (71) et un corps de liaison (72) fixé de manière rigide au-dessus du corps principal, une aire de section transversale du corps de liaison étant inférieure à une aire de section transversale du corps principal, la forme de la fente de réception (6) correspondant à la forme du bloc conducteur thermique, un épaulement (711) étant ménagé à une position sur le corps principal (71) correspondant à celle où le corps de liaison (72) est assemblé, l'épaulement (711) étant parallèle à une surface de la première carte noyau (21), et l'épaulement (711) étant situé sur une surface inférieure de la couche intermédiaire (3),
**caractérisée en ce qu'**un via conducteur thermique (8) en liaison avec le bloc conducteur thermique (7) est ouvert à côté du bloc conducteur thermique.

3. Carte de circuit imprimé multicouche selon la revendication 1, dans laquelle la deuxième carte noyau est située à une extrémité ou à deux extrémités de la fente de réception.

4. Carte de circuit imprimé multicouche selon la revendication 2, dans laquelle toutes les cartes assemblées (2) sont des premières cartes noyaux (21), et dans laquelle deux extrémités du bloc conducteur thermique sont situées au niveau d'une surface externe de la carte de circuit imprimé multicouche après que le bloc conducteur thermique a été placé dans la fente de réception.

5. Carte de circuit imprimé multicouche selon la revendication 2, dans laquelle le corps de liaison (72) est formé d'une seule pièce, ou comprend plus de deux sous-corps de liaison (721).

6. Carte de circuit imprimé multicouche selon la revendication 2 ou 5, dans laquelle le bloc conducteur thermique comprend en outre une pièce de liaison, la pièce de liaison est fixée de manière rigide au-dessous du corps principal, une aire de section transversale de la pièce de liaison est inférieure à une aire de section transversale du corps principal.

7. Carte de circuit imprimé multicouche selon l'une quelconque des revendications 1 à 6, dans laquelle le bloc conducteur thermique est constitué d'un matériau présentant une conductivité thermique supérieure à une conductivité thermique de la carte de circuit imprimé.

8. Dispositif de communication, comprenant au moins une carte de circuit imprimé multicouche selon l'une quelconque des revendications 1 à 7.
